# EUROPÄISCHE PATENTSCHRIFT

(11) **EP 2 909 831 B1**
(45) Veröffentlichungstag und Bekanntmachung des Hinweises auf die Patenterteilung: **12.08.2020**
(21) Anmeldenummer: 13774685.5
(22) Anmeldetag: 11.10.2013
(51) Int. Cl.: G10K 9/22, G01S 7/521

(54) **ULTRASCHALLSENSORVORRICHTUNG MIT EINER VERSTEIFUNGSEINHEIT, ANORDNUNG, KRAFTFAHRZEUG UND VERFAHREN ZUM HERSTELLEN EINER ANORDNUNG**
ULTRASONIC SENSOR DEVICE HAVING A STIFFENING UNIT, ASSEMBLY, MOTOR VEHICLE, AND METHOD FOR PRODUCING AN ASSEMBLY
DISPOSITIF AVEC UN CAPTEUR À ULTRASONS COMPORTANT UN ÉLÉMENT RAIDISSEUR, ENSEMBLE, VÉHICULE À MOTEUR ET PROCÉDÉ DE FABRICATION D'UN ENSEMBLE

(30) Priorität: 16.10.2012 DE 102012109838
(43) Veröffentlichungstag der Anmeldung: 26.08.2015
(73) Patentinhaber: Valeo Schalter und Sensoren GmbH, 74321 Bietigheim-Bissingen (DE); Volkswagen Aktiengesellschaft, 38440 Wolfsburg (DE)
(72) Erfinder: WEHLING, Hans-Wilhelm, 74074 Heilbronn (DE); WEYLAND, Joerg, 74336 Brackenheim (DE); WEBER, Natalie, 74321 Bietigheim-Bissingen (DE)
(74) Vertreter: Hofstetter, Schurack & Partner
(86) Internationale Anmeldenummer: PCT/EP2013/071317
(87) Internationale Veröffentlichungsnummer: WO 2014/060317

(56) Entgegenhaltungen:
- DE-A1- 19 727 877
- DE-A1-102008 062 011
- DE-A1-102010 044 996

## Beschreibung

Die Erfindung betrifft eine Ultraschallsensorvorrichtung für ein Kraftfahrzeug, umfassend einen Ultraschallsensor, welcher eine Membran zum Aussenden und/oder Empfangen von Ultraschallwellen aufweist, sowie umfassend eine Versteifungseinheit zum Anbringen an einem Verkleidungsteil des Kraftfahrzeugs und zum Versteifen des Verkleidungsteils, wobei die Versteifungseinheit eine Durchgangsöffnung für die Membran des Ultraschallsensors bildet, so dass insbesondere die Membran durch diese Durchgangsöffnung hindurch gesteckt und in Anlage mit einer Rückseite des Verkleidungsteils gebracht werden kann. Die Erfindung betrifft außerdem eine Anordnung für ein Kraftfahrzeug, mit einem Verkleidungsteil, insbesondere einem Stoßfänger, und mit einer derartigen Ultraschallsensorvorrichtung. Des Weiteren betrifft die Erfindung ein Kraftfahrzeug mit einer solchen Anordnung, wie auch ein Verfahren zum Herstellen einer Anordnung.

Ultraschallsensoren sind bereits Stand der Technik und können in bekannter Weise im Frontbereich und im Heckbereich eines Kraftfahrzeugs verbaut werden, nämlich beispielsweise an den jeweiligen Stoßfängern. Die Ultraschallsensoren sind Fahrerassistenzeinrichtungen zugeordnet und liefern Informationen über die Fahrzeugumgebung, und genauer gesagt über die Abstände zwischen dem Kraftfahrzeug einerseits und den in seiner Umgebung befindlichen Hindernissen andererseits. Fahrerassistenzeinrichtungen können dabei beispielsweise Parkassistenzsysteme, Systeme zur Totwinkelüberwachung, Systeme zur Abstandshaltung, Bremsassistenzsysteme, Kollisionserkennungssysteme und dergleichen sein.

Es ist bereits Stand der Technik, dass derartige Ultraschallsensoren in einem Stoßfänger unverdeckt verbaut angeordnet sind. Dies bedeutet, dass die Ultraschallsensoren in durchgängigen Aussparungen bzw. Durchgangsöffnungen in dem Stoßfänger angeordnet sind und außenseitig sichtbar sind. Hier erstreckt sich die topfförmige Membran des Ultraschallsensors - der sogenannte Aluminiumtopf - durch die Durchgangsöffnung des Stoßfängers hindurch, so dass eine Frontseite bzw. frontale Fläche der Membran mit der äußeren Oberfläche des Stoßfängers bündig abschließt. Die Frontseite der Membran kann hier beispielsweise in der Farbe des Stoßfängers lackiert sein. Zur schwingungstechnischen Entkopplung der Membran von dem Stoßfänger wird üblicherweise ein Entkopplungsring aus einem weichen Material verwendet, welcher um die Membran herum angeordnet ist und an einem Außenumfang der topfförmigen Membran anliegt. Dieser Entkopplungsring ist beispielsweise aus Silikon gebildet.

Vorliegend gilt das Interesse jedoch einer verdeckten Anordnung eines Ultraschallsensors, wie sie bereits beispielsweise aus dem Dokument DE 42 38 924 A1 oder aber aus dem Dokument DE 10 2008 018 110 A1 bekannt ist. Bei einer solchen versteckten Anordnung ist der Ultraschallsensor hinter dem Stoßfänger verdeckt angeordnet, so dass die Frontseite der topfförmigen Membran an einer Rückseite des Stoßfängers anliegt, welche dem Innenraum des Fahrzeugs zugewandt ist. Die Ultraschallwellen werden somit durch das Material des Stoßfängers hindurch ausgesendet und empfangen. Hier muss ein geeigneter Halter eingesetzt werden, um die Membran bzw. den gesamten Ultraschallsensor einschließlich der Membran an der Rückseite des Stoßfängers befestigen zu können. Es ist diesbezüglich bereits bekannt, dass eine solche Halteeinrichtung (insbesondere über ein Versteifungselement) über einen Klebstoff mit dem Stoßfänger verbunden wird, während der Ultraschallsensor selbst reversibel lösbar (und zerstörungsfrei lösbar) mit der Halteeinrichtung verbunden werden kann.

Bei den verdeckt angeordneten Ultraschallsensoren ist also die Membran hinter dem Stoßfänger angebracht und liegt insbesondere direkt an der Rückseite des Stoßfängers an. Die Ultraschallsignale werden durch das Material des Stoßfängers hindurch gesendet und empfangen. Dies bedeutet, dass auch ein bestimmter Bereich des Stoßfängers mitschwingt. Dieser schwingende Bereich des Stoßfängers soll mit Hilfe einer aus einem steifen Material - etwa aus Keramik - gebildeten Versteifungseinheit begrenzt werden, welche im Stand der Technik in Form eines einzigen Versteifungselements bereitgestellt wird. Die Versteifungseinheit soll die Schwingung des Stoßfängers auf einen Bereich reduzieren, dessen Größe dem Durchmesser der Membran entspricht. Die schwingende Fläche des Stoßfängers sollte demnach nur so groß wie der Durchmesser der Membran des Ultraschallsensors sein. Gerade aus diesem Grund wird die Versteifungseinheit aus einem steifen Material um die Membran herum bzw. um den oben genannten und aus einem weichen und elastischen Material bereitgestellten Entkopplungsring herum eingesetzt, welche ringförmig ausgebildet ist und die Membran außenumfänglich umgibt. Der oben genannte Entkopplungsring kann also gegebenenfalls zwischen der Membran einerseits und der Versteifungseinheit andererseits angeordnet sein.

Die Versteifungseinheit kann ihre Funktion grundsätzlich nur dann erfüllen, wenn sie mechanisch vollflächig fest mit der Rückseite des Stoßfängers verbunden ist. Nur bei einer kompletten flächigen festen Verbindung der Versteifungseinheit ist gewährleistet, dass keine unerwünscht hohen Schwingungen auf den restlichen Bereich des Stoßfängers übertragen werden. An die Verbindung zwischen dem Stoßfänger und der Versteifungseinheit werden dabei relativ hohe Anforderungen gestellt: Die Verbindung muss über die gesamte Lebensdauer des Fahrzeugs sowie über den geforderten Temperaturbereich von -40°C bis +90 °C aushalten. Deshalb wird üblicherweise ein Klebstoff verwendet, welcher den Anforderungen an die Haftung, Temperaturbeständigkeit, geringe Alterung, geringen Steifigkeitsverlust über Temperatur, geringe Schichtdicke, wie auch geringe Wasseraufnahme genügt.

Es hat sich gezeigt, dass aufgrund der Schwingung des Versteifungselements Mikrorisse in der Klebeverbindung entstehen können, welche lokal zu Enthaftungen der Verbindung führen. Somit entstehen lokale Haftungsprobleme, so dass die schwingende Fläche des Stoßfängers nicht mehr zuverlässig auf die Größe der Membran begrenzt werden kann. Solche Risse können beispielsweise durch eine schlechte Verklebung etwa wegen nicht gereinigten Klebeflächen entstehen. Die Entstehung solcher Risse wird zusätzlich noch durch große Unterschiede in den Längenausdehnungskoeffizienten zwischen dem Versteifungselement und dem Stoßfänger unterstützt. Es hat sich auch herausgestellt, dass es im Betrieb des Fahrzeugs zu einer Schwingung der Versteifungseinheit mit einer relativ großen Schwingungsamplitude kommen kann. Diese Schwingung wird dann an den Stoßfänger übertragen, so dass auch der Stoßfänger außerhalb des Außendurchmessers des Versteifungsteils schwingt und somit eine Schallabstrahlung nach hinten bzw. in Richtung zur Fahrzeugkarosserie hin erfolgt. Diese Schallwellen reflektieren dann an den Karosserieteilen und gelangen aus dem rückwärtigen Bereich wieder zum Sensor, nämlich als Störecho bzw. Scheinecho. Somit ist man im Stand der Technik dazu gezwungen, zusätzliche Maßnahmen zur Unterdrückung der rückwärtigen Störechos zu treffen.

Aus der DE 10 2008 062 011 A1 ist eine Befestigungsanordnung zur Befestigung eines Sensors an einem Fahrzeug bekannt.

Aus der DE 10 2010 044 996 A1 ist eine Sensoranordnung für ein Fahrzeug bekannt. Die Sensoranordnung weist ein ringförmiges Versteifungsteil auf. Dieses Versteifungsteil kann aus einem keramischen Material und/oder aus Stahl ausgebildet sein. Es kann auch ein hochgefüllter Kunststoff sein, der mit einer Füllung aus Keramik und/oder Stahl gefüllt ist. Das Versteifungsteil ist eine ringförmige Hülse.

Es ist Aufgabe der Erfindung, eine Lösung aufzuzeigen, wie bei einer Ultraschallsensorvorrichtung der eingangs genannten Gattung eine zuverlässige Versteifung des Verkleidungsteils mittels der Versteifungseinheit ermöglicht werden kann. Diese Aufgabe wird erfindungsgemäß durch eine Ultraschallsensorvorrichtung, durch eine Anordnung, wie auch durch ein Kraftfahrzeug sowie durch ein Verfahren mit den Merkmalen gemäß den jeweiligen unabhängigen Patentansprüchen gelöst. Vorteilhafte Ausführungen der Erfindung sind Gegenstand der abhängigen Patentansprüche, der Beschreibung und der Figuren.

Eine Ultraschallsensorvorrichtung für ein Kraftfahrzeugs umfasst einen Ultraschallsensor, welcher eine Membran zum Aussenden und/oder Empfangen von Ultraschallwellen aufweist, wie auch eine Versteifungseinheit zum Anbringen an einem Verkleidungsteil des Kraftfahrzeugs und zum Versteifen des Verkleidungsteils, nämlich insbesondere zum Begrenzen einer mechanischen Schwingung des Verkleidungsteils im Wesentlichen auf die Größe der Membran. Die Versteifungseinheit weist im zusammengebauten Zustand eine Durchgangsöffnung für die Membran des Ultraschallsensors auf. Die Versteifungseinheit ist in zumindest zwei separate Versteifungsteile unterteilt und somit segmentiert ausgebildet, wobei die separaten Versteifungsteile zum Anbringen an dem Verkleidungsteil und zum Versteifen des Verkleidungsteils um die Membran herum ausgebildet sind.

Die Erfindung geht also den Weg, statt eine einstückige Versteifungseinheit in Form eines Versteifungsringes einzusetzen, die Versteifungseinheit - insbesondere bei im Wesentlichen gleich bleibender Gesamtgröße - in zumindest zwei Versteifungsteile bzw. Versteifungselemente zu unterteilen, welche separat voneinander bereitgestellt und in einem geringen Abstand zueinander angeordnet sind, etwa in einem Abstand kleiner als 3 mm, insbesondere kleiner als 2 mm. Es hat sich nämlich herausgestellt, dass eine einstückig ausgebildete Versteifungseinheit in Kombination mit dem Material des Verkleidungsteils (etwa mit Polypropylen-Kunststoff) über die vorgeschriebene Betriebstemperatur von -40° C bis +90°C zu unterschiedlichen Schwingungsformen neigt. Je nach Schwingform der Versteifungseinheit ergibt sich dann eine mehr oder weniger starke Schwingung des Verkleidungsteils um den Außendurchmesser der Versteifungseinheit. Diese Schwingungen außerhalb des Außendurchmessers der Versteifungseinheit verursachen dann eine Ausbreitung der Ultraschallwellen in Richtung zum Innenraum des Fahrzeugs, so dass die Ultraschallwellen an Fahrzeugteilen reflektieren und als rückwärtige Echos wieder zum Ultraschallsensor gelangen. Somit müssen im Stand der Technik zusätzliche Dämpfungsmaßnahmen getroffen werden, welche zur Eindämmung der Schallabstrahlung nach hinten in Richtung zur Fahrzeugkarosserie hin dienen. Höhere Schwingungen können jedoch nur dann entstehen, wenn die Versteifungseinheit einstückig ausgebildet ist. Um diese Abstrahlung von Ultraschallwellen in Richtung zum Fahrzeuginnenraum zu minimieren, wird die Versteifungseinheit in mehrere Einzelteile eingeteilt. Somit ist einerseits sichergestellt, dass die Funktion der Versteifungseinheit - nämlich die Versteifung des Verkleidungsteils -weiterhin durch den verwendeten Werkstoff sowie durch die mechanische Verbindung mit dem Verkleidungsteil erhalten bleibt. Auf der anderen Seite wird jedoch zusätzlich noch erreicht, dass sich die einzelnen Versteifungsteile bezüglich ihrer Geometrie nicht mehr so stark wie ein einstückiger Versteifungsring verbiegen und kritische Schwingformen je nach Frequenz erzeugen können. Einzelne Versteifungsteile sind nämlich deutlich stabiler, weil sie einzeln im Vergleich zu einem einstückigen Versteifungsring in der Fläche parallel zum Verkleidungsteil deutlich kleiner sind. Mit anderen Worten ist die Schwingungsamplitude der einzelnen kleineren Versteifungsteile deutlich geringer als die Schwingungsamplitude eines einstückigen Versteifungsringes, so dass auch eine geringere Schwingung an das Verkleidungsteil übertragen wird. Ein weiterer Vorteil besteht darin, dass die Eigenschaften der Versteifungseinheit bezüglich weiterer Anforderungen - wie insbesondere der Ausschwingzeit, der Richtcharakteristik und dergleichen - erhalten geblieben sind. Die Erfindung hat also den Vorteil, dass es gegebenenfalls auf zusätzliche Maßnahmen zur Unterdrückung der Schallausbreitung nach hinten in Richtung zum Fahrzeuginnenraum hin verzichtet werden kann, so dass sich beispielsweise der Einsatz einer Kappe oder aber der Einsatz von zusätzlichen weichen Dämpfungsmatten mit den damit verbundenen Nachteilen gegebenenfalls erübrigen kann. Dies gilt vorzugsweise nur in Verbindung mit bestimmten Materialien des Verkleidungsteils, wie insbesondere dem modifizierten Polypropen mit der Bezeichnung "BMU 130".

Die Erfindung macht sich folglich die Tatsache zunutze, das sich größere Schwingungen bzw. größere Schwingungsamplituden in einer Struktur ausschließlich im Bereich der Eigenfrequenz aufgrund einer äußeren Energiezufuhr ausbilden kann. Im Stand der Technik wird die als einstückiger Ring ausgebildete Versteifungseinheit zwar hinsichtlich des verwendeten Materials sowie der geometrischen Abmessungen so ausgelegt, dass sie im Bereich der Betriebsfrequenz des Ultraschallsensors möglichst keine Eigenresonanzen besitzt und somit keine größeren Schwingungsamplituden der Versteifungseinheit möglich sind, jedoch können sich dennoch bei äußerer Energiezufuhr hohe Schwingungsamplituden und somit Schwingungsformen ausbilden. Bei einem hinter dem Verkleidungsteil versteckten Ultraschallsensor wird die Betriebsfrequenz nämlich maßgeblich von dem Elastizitätsmodul des Verkleidungsteils bestimmt. Insbesondere bei Kunststoffen ist dieses Elastizitätsmodul stark von der Temperatur abhängig. Die Versteifungseinheit muss deshalb auch über einen größeren Frequenzbereich - nämlich etwa von 30 kHz bis 100 kHz - so ausgestaltet werden, dass sie möglichst wenig Schwingungsenergie aufnehmen kann und sich somit keine höheren Schwingungsformen ausbilden können. Die Erfindung beruht nun auf der Erkenntnis, dass die Schwingungsamplituden bei einer einstückig ausgebildeten Versteifungseinheit deutlich höher als bei einer segmentierten bzw. mehrere Versteifungsteile aufweisenden Versteifungseinheit ausfallen.

Die Versteifungseinheit hat eine Durchgangsöffnung für die Membran des Ultraschallsensors. Dies bedeutet, dass im zusammengebauten bzw. im montierten Zustand der Ultraschallsensorvorrichtung die Versteifungseinheit um die - insbesondere topfförmige - Membran des Ultraschallsensors herum angeordnet ist und somit selbige Membran außenumfänglich umgibt. Zwischen der Membran einerseits und der Versteifungseinheit andererseits befindet sich vorzugsweise ein aus einem weich-elastischen Material gebildeter Entkopplungsring, welcher an einem Umfang der topfförmigen Membran anliegt und die Membran somit außenumfänglich ummantelt. Die Versteifungseinheit ist somit eine von einem solchen Entkopplungsring verschiedene bzw. separate Einheit.

Die zumindest zwei Versteifungsteile sind beabstandet zueinander angeordnet.

Im Allgemeinen kann die Versteifungseinheit in Umfangsrichtung und in radialer Richtung jeweils in zumindest zwei Versteifungsteile unterteilt sein.

Es ist vorgesehen, dass in Umfangsrichtung die Versteifungseinheit in zumindest zwei Versteifungsteile eingeteilt ist, die in Umfangsrichtung beabstandet zueinander bzw. in einem geringen Abstand zueinander angeordnet sind. Vorzugsweise sind diese Versteifungsteile in Form von Ringsektoren ausgebildet. Die Versteifungseinheit umfasst bevorzugt zumindest eine Ringstruktur, welche in Umfangsrichtung in zumindest zwei Ringsektoren als Versteifungsteile unterteilt ist. Somit können insgesamt kleinere Versteifungsteile bereitgestellt werden, so dass die Schwingungsamplitude der einzelnen Versteifungsteile über den gesamten geforderten Temperaturbereich sehr gering ist. Es gilt dabei grundsätzlich die Beziehung, dass je mehr solche Versteifungsteile vorgesehen sind bzw. je kleiner die Versteifungsteile sind, desto geringer die maximale Schwingungsamplitude der Versteifungsteile ist und somit geringer die Energie der nach hinten abgestrahlten Ultraschallwellen ist.

Ergänzend oder alternativ kann die Versteifungseinheit auch in radialer Richtung zumindest zwei konzentrisch zueinander angeordnete Ringstrukturen aufweisen, welche in radialer Richtung beabstandet zueinander angeordnet sind. Bei einer vorgegebenen Gesamtgröße der Versteifungseinheit kann somit die Größe der einzelnen Versteifungsteile und somit die maximal mögliche Schwingungsamplitude weiterhin reduziert werden.

Wird die Versteifungseinheit sowohl in Umfangsrichtung als auch in radialer Richtung unterteilt, so kann zumindest eine der Ringstrukturen in Umfangsrichtung in zumindest zwei Ringsektoren als Versteifungsteile unterteilt sein, welche in Umfangsrichtung beabstandet zueinander angeordnet sind. Die Unterteilung der Versteifungseinheit sowohl in Umfangsrichtung als auch in radialer Richtung erweist sich insbesondere bei einem Verkleidungsteil als besonders vorteilhaft, dessen Material einen Elastizitätsmodul aufweist, welcher besonders stark temperaturabhängig ist. Durch Unterteilung der Versteifungseinheit sowohl in Umfangsrichtung als auch in radialer Richtung wird nämlich eine Versteifungseinheit geschaffen, welche über einen sehr breiten Frequenzbereich sowie über einen großen Temperaturbereich sehr geringe Schwingungsenergie aufnehmen und somit zu keiner großen Schwingung angeregt werden kann.

Sind zumindest zwei solche konzentrische Ringstrukturen in Umfangsrichtung jeweils in zumindest zwei Ringsektoren bzw. Versteifungsteile unterteilt, so können die Versteifungsteile einer ersten Ringstruktur winkelversetzt zu den Versteifungsteilen der benachbarten zweiten Ringstruktur angeordnet sein. Dies bedeutet, dass die zwischen den in Umfangsrichtung benachbarten Versteifungsteilen ausgebildeten Schlitze der erste Ringstruktur einerseits und der zweiten Ringstruktur andererseits in unterschiedlichen Winkelpositionen zueinander angeordnet sind.

Alternativ kann jedoch auch vorgesehen sein, dass die Versteifungsteile der ersten Ringstruktur einerseits und die der zweiten Ringstruktur andererseits in gleichen Winkelpositionen zueinander angeordnet sind. Dies bedeutet, dass die genannten Schlitze der ersten Ringstruktur einerseits und die der zweiten Ringstruktur andererseits in gleichen Winkelpositionen liegen.

Bevorzugt ist durch die Versteifungseinheit insgesamt eine Ringform gebildet bzw. die Versteifungseinheit weist insgesamt eine Ringform auf, welche in Umfangsrichtung und/oder in radialer Richtung in zumindest zwei Versteifungsteile unterteilt ist. Somit ist einerseits die Durchgangsöffnung für die Membran des Ultraschallsensors bereitgestellt. Auf der anderen Seite kann eine solche ringförmige Versteifungseinheit auch ohne viel Aufwand in die bereits bestehenden bzw. für einstückige Versteifungselemente bereits entwickelten Halteeinrichtungen integriert werden, die zur Befestigung des Ultraschallsensors an dem Verkleidungsteil des Kraftfahrzeugs dienen. Beispielsweise kann die Versteifungseinheit mit der Halteeinrichtung verklebt werden, wobei die geometrische Form der Halteeinrichtung nicht zusätzlich an die Versteifungseinheit angepasst zu werden braucht.

Die Bereitstellung der zumindest zwei Versteifungsteile ermöglicht es zumindest zwei Versteifungsteile (der zumindest zwei Versteifungsteile) aus unterschiedlichen Materialien auszugestalten. Somit wird die Versteifungswirkung über die Fläche des Verkleidungsteils abhängig von den Anforderungen variiert. Selbst bei unterschiedlichen Materialien ist jedoch bevorzugt vorgesehen, dass diese unterschiedlichen Materialien keramische Materialien sind, welche besonders steif sind.

Insbesondere sind also die zumindest zwei Versteifungsteile aus Keramik gebildet. Die Erfindung ist jedoch nicht auf ein solches spezifisches Material beschränkt, und es können auch andere Materialien eingesetzt werden, welche eine ähnliche Steifheit bzw. Festigkeit aufweisen.

Zumindest eines der Versteifungsteile kann dabei aus Aluminiumoxid und/oder aus Siliziumcarbid gebildet sein. Es hat sich nämlich herausgestellt, dass diese Materialien für die Versteifung eines Verkleidungsteils eines Kraftfahrzeugs ausreichend steif sind.

Um den Fertigungsaufwand zu reduzieren, können die zumindest zwei Versteifungsteile über einen Steg miteinander verbunden sein, welcher aus einem gegenüber dem Material der Versteifungseinheit weniger steifen Material gebildet ist. Somit ist die Handhabung der Versteifungseinheit besonders aufwandsarm, weil alle Versteifungsteile auch gleichzeitig stabil gehandhabt werden können. Insbesondere ist der Steg aus einem nicht-versteifenden und bevorzugt aus einem weichen Material gebildet, durch welches die zumindest zwei Versteifungsteile schwingungstechnisch voneinander entkoppelt sind. Dies bedeutet insbesondere, dass keine feste - insbesondere keine keramische-Verbindung zwischen den einzelnen Versteifungsteilen vorgesehen ist und der Steg lediglich fertigungstechnisch die Montage der Ultraschallsensorvorrichtung vereinfachen soll. Der Steg trägt somit nicht zur Versteifung des Verkleidungsteils bei und ist folglich kein Bestandteil der Versteifungseinheit.

Bevorzugt weist die Ultraschallsensorvorrichtung eine mit der Versteifungseinheit verbundene Halteeinrichtung auf, an welcher der Ultraschallsensor, insbesondere zerstörungsfrei reversibel lösbar, befestigbar ist. Die Halteeinrichtung kann mit der Versteifungseinheit beispielsweise verklebt sein. Die lösbare Verbindung zwischen dem Ultraschallsensor und der Halteeinrichtung kann insbesondere als Rastverbindung ausgebildet sein. Eine solche Halteeinrichtung hat insbesondere den Vorteil, dass der Ultraschallsensor alleine von dem Verkleidungsteil gelöst werden kann, ohne dass auch die Halteeinrichtung oder aber die Versteifungseinheit zusammen mit dem Ultraschallsensor gelöst werden müssen. Im Falle einer Reparatur oder aber eines Austausches des Ultraschallsensors ist der Aufwand bei der Demontage des Ultraschallsensors somit minimal.

Die Versteifungseinheit wird bevorzugt mit ihrer Frontseite mit der Rückseite des Verkleidungsteils verbunden, insbesondere verklebt. Die Rückseite der Versteifungseinheit wird hingegen mit der Halteeinrichtung verbunden, insbesondere verklebt. Alternativ kann die Versteifungseinheit auch mittels einer Rastverbindung mit der Halteeinrichtung verbunden werden.

Die Halteeinrichtung weist bevorzugt eine Durchgangsöffnung auf, durch welche die Membran des Ultraschallsensors hindurch gesteckt wird, um mit der Rückseite des Verkleidungsteils in Anlage gebracht zu werden.

Eine erfindungsgemäße Anordnung für ein Kraftfahrzeug umfasst ein Verkleidungsteil, insbesondere einen Stoßfänger, und eine an einer Rückseite des Verkleidungsteils angeordnete erfindungsgemäße Ultraschallsensorvorrichtung, wobei der Ultraschallsensor zum Aussenden und/oder Empfangen der Ultraschallwellen durch das Verkleidungsteil hindurch ausgebildet ist und die Versteifungseinheit an der Rückseite des Verkleidungsteils anliegend angebracht ist. Bevorzugt liegt auch die Frontseite der Membran an der Rückseite des Verkleidungsteils an, insbesondere vollflächig.

Die Rückseite des Verkleidungsteils ist diejenige Seite, welche dem Innenraum des Fahrzeugs zugewandt und somit von außerhalb nicht sichtbar ist.

Die Erfindung betrifft auch ein Kraftfahrzeug mit einer erfindungsgemäßen Anordnung.

Ein erfindungsgemäßes Verfahren dient zum Herstellen einer Anordnung für ein Kraftfahrzeug durch Bereitstellen eines Verkleidungsteils, insbesondere eines Stoßfängers, Bereitstellen eines Ultraschallsensors mit einer Membran zum Aussenden und/oder Empfangen von Ultraschallwellen, und Bereitstellen einer Versteifungseinheit und Anbringen der Versteifungseinheit an einer Rückseite des Verkleidungsteils, wobei die Versteifungseinheit eine Durchgangsöffnung aufweist, durch welche die Membran hindurch gesteckt wird. Die Versteifungseinheit wird aus zumindest zwei separaten Versteifungsteilen segmentiert ausgebildet.

Die mit Bezug auf die erfindungsgemäße Ultraschallsensorvorrichtung vorgestellten bevorzugten Ausführungsformen und deren Vorteile gelten entsprechend für die erfindungsgemäße Anordnung, für das erfindungsgemäße Kraftfahrzeug, wie auch für das erfindungsgemäße Verfahren.

Weitere Merkmale der Erfindung ergeben sich aus den Ansprüchen, den Figuren und der Figurenbeschreibung. Alle vorstehend in der Beschreibung genannten Merkmale und Merkmalskombinationen sowie die nachfolgend in der Figurenbeschreibung genannten und/oder in den Figuren alleine gezeigten Merkmale und Merkmalskombinationen sind nicht nur in der jeweils angegebenen Kombination, sondern auch in anderen Kombinationen oder aber in Alleinstellung verwendbar.

Die Erfindung wird nachfolgend anhand einzelner bevorzugter Ausführungsbeispiele, wie auch unter Bezugnahme auf die beigefügten Zeichnungen näher erläutert.

Es zeigen:
- Fig. 1: in schematischer und perspektivischer Darstellung eine Ultraschallsensorvorrichtung gemäß einer Ausführungsform der Erfindung;
- Fig. 2: in schematischer Darstellung eine Schnittansicht durch eine Anordnung gemäß einer Ausführungsform der Erfindung;
- Fig. 3: in schematischer Darstellung eine Draufsicht bzw. eine Schnittdarstellung durch eine Versteifungseinheit gemäß einem ersten Ausführungsbeispiel;
- Fig. 4: in schematischer Darstellung eine Draufsicht bzw. eine Schnittdarstellung durch eine Versteifungseinheit gemäß einem zweiten Ausführungsbeispiel; und
- Fig. 5: in schematischer und perspektivischer Darstellung eine Ringstruktur einer Versteifungseinheit.

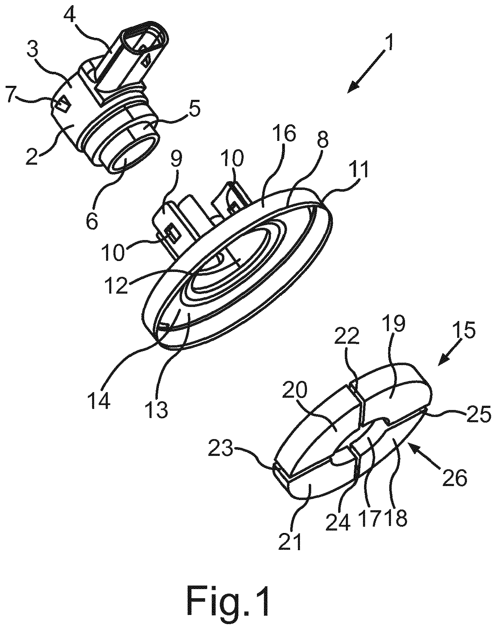

In Fig. 1 ist in schematischer Darstellung eine Ultraschallsensorvorrichtung 1 gemäß einer Ausführungsform der Erfindung gezeigt. Die Ultraschallsensorvorrichtung 1 umfasst einen Ultraschallsensor 2, welcher ein Sensorgehäuse 3 mit einem Stecker 4 aufweist, der zum Verbinden des Sensors 2 mit einer elektronischen Steuereinrichtung eines Kraftfahrzeugs dient. Aus dem zylindrischen Sensorgehäuse 3 ragt eine topfförmige Membran 5 heraus, welche zum Aussenden und Empfangen von Ultraschallsignalen bzw. Ultraschallwellen ausgebildet ist. Die Membran 5 ist in Form eines Topfes ausgebildet und beispielsweise aus Aluminium. Sie hat eine Frontseite 6, durch welche die Ultraschallwellen ausgesendet werden. Die mechanische Anregung der Frontseite 6 kann beispielsweise mit Hilfe eines piezoelektrischen Elements erfolgen, welches im Inneren der Membran 5 auf einem Boden der Membran 5 platziert ist, welcher der Frontseite 6 gegenüberliegt.

An dem Sensorgehäuse 3 sind Rastelemente 7 ausgebildet, über welche der Ultraschallsensor 2 an einer Halteeinrichtung 8 zerstörungsfrei reversibel lösbar befestigt werden kann. Die Halteeinrichtung 8 ist einstückig ausgebildet und hat einen Aufnahmeschacht 9, in welchem korrespondierende Rastöffnungen bzw. Rastlaschen 10 ausgebildet sind, in welche die Rastelemente 7 verrasten können. Die Halteeinrichtung 8 hat außerdem einen Untersatz 11, welcher konzentrisch zum zylinderförmigen Aufnahmeschacht 9 angeordnet ist und ebenfalls zylindrisch ausgebildet ist sowie einen größeren Durchmesser als der Aufnahmeschacht 9 aufweist. Die Halteeinrichtung 8 weist eine zentrale Durchgangsöffnung 12 auf, durch welche sich die Membran 5 im verbauten Zustand hindurch erstreckt, um an einem Verkleidungsteil des Kraftfahrzeugs anliegen zu können.

Auf seiner vom Ultraschallsensor 2 abgewandten Frontseite bzw. Vorderseite weist der Untersatz 11 eine Aufnahme 13 mit einem Boden 14 auf, in welche eine aus einem steifen Material gebildete Versteifungseinheit 15 eingesetzt werden kann. Die Aufnahme 13 ist seitlich durch einen umlaufenden Steg 16 begrenzt, an dessen Innenumfang gegebenenfalls Raststrukturen zur Verrastung der Versteifungseinheit 15 angeformt sein können.

Auch die Versteifungseinheit 15 hat eine Durchgangsöffnung 17, durch welche sich die Membran 5 im montierten Zustand hindurch erstreckt.

Im Ausführungsbeispiel gemäß Fig. 1 ist vorgesehen, dass die Versteifungseinheit 15 insgesamt die Form eines Ringes aufweist und somit eine einzige Ringstruktur mit der Durchgangsöffnung 17 bildet. Die Versteifungseinheit 15 ist dabei in Umfangsrichtung in insgesamt vier gleiche Ringsektoren bzw. Versteifungsteile 18, 19, 20, 21 unterteilt, welche in Umfangsrichtung in einem geringen Abstand zueinander angeordnet sind. In Umfangsrichtung sind somit zwischen den einzelnen Versteifungsteilen 18 bis 21 Schlitze 22 bis 25 ausgebildet, welche sich in radialer Richtung geradlinig erstrecken. Die einzelnen Versteifungsteile 18 bis 21 berühren sich somit nicht.

Im Beispiel gemäß Fig. 1 weist die Versteifungseinheit 15 eine einzige solche Ringstruktur mit vier Versteifungsteilen 18 bis 21 auf. Es können jedoch auch mehrere solche Ringstrukturen vorgesehen sein, welche konzentrisch zueinander angeordnet sind und jeweils beispielsweise in mehrere Versteifungsteile in Umfangsrichtung unterteilt sind.

Gemäß einem Beispiel, das nicht Teil der Erfindung ist, sind die Versteifungsteile 18 bis 21 beispielsweise alle aus dem gleichen Material gebildet. Lediglich beispielhaft sei an dieser Stelle ein keramisches Material genannt, wie beispielsweise Aluminiumoxid und/oder Siliziumcarbid.

Die Versteifungseinheit 15 dient zum Versteifen eines Verkleidungsteils des Kraftfahrzeugs, etwa des Stoßfängers, an welchem die Ultraschallsensorvorrichtung angebracht wird. Die Versteifungseinheit 15 hat eine Frontseite 26, welche mit der Rückseite des Verkleidungsteils verbunden, insbesondere verklebt, wird. Andererseits kann die Versteifungseinheit 15 in die Aufnahme 13 der Halteeinrichtung 8 aufgenommen und mit dem Boden 14 und/oder dem Steg 16 verbunden werden. Auch hier kann eine Klebeverbindung vorgesehen sein. Ergänzend oder alternativ können zu diesem Zwecke auch Rastelemente eingesetzt werden.

Die Halteeinrichtung 8 wird also über die Versteifungseinheit 15 an der Rückseite des Verkleidungsteils angebracht. Der Ultraschallsensor 2 kann dabei in einfacher Weise an der Halteeinrichtung 8 über die Rastelemente 7 reversibel lösbar befestigt werden. Lediglich die Frontseite 6 der Membran 5 kann über einen geeigneten Klebstoff mit der Rückseite des Verkleidungsteils verbunden werden.

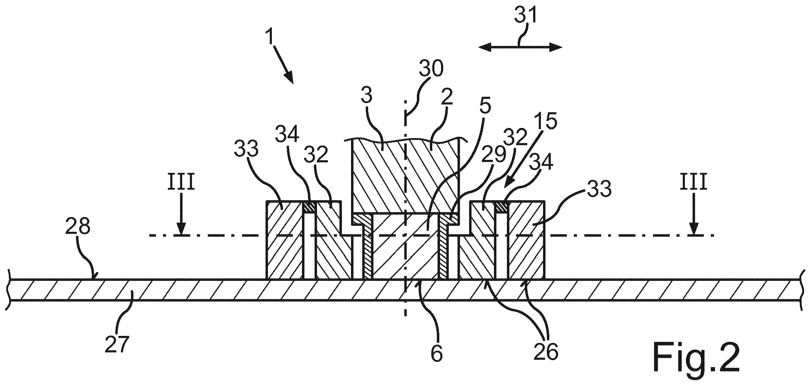

Eine Anordnung gemäß einer Ausführungsform der Erfindung ist in einer Schnittansicht in Fig. 2 dargstellt. Die Anordnung umfasst ein Verkleidungsteil 27 des Kraftfahrzeugs, etwa einen Stoßfänger. An einer dem Innenraum des Fahrzeugs zugewandten Rückseite 28 des Verkleidungsteils 27 ist die Ultraschallsensorvorrichtung 1 angebracht. Die Halteeinrichtung 8 ist dabei nicht dargestellt.

Die Frontseite 6 der Membran 5 liegt direkt an der Rückseite 28 des Verkleidungsteils 27 an. Um die Membran 5 herum ist ein Entkopplungsring 29 angeordnet, welcher aus einem weich-elastischen Material gebildet ist, etwa aus Silikon. Dieser Entkopplungsring 29 ist auf die topfförmige Membran 5 aufgesteckt und liegt an dem Außenumfang der Membran 5 an. Die Frontseite 6 der Membran 5 ist frei von einem solchen Entkopplungsring 29.

Der Ultraschallsensor 2 sendet also die Ultraschallwellen durch das Material des Verkleidungsteils 27 hindurch. Die Sensorachse bzw. Längsachse des Ultraschallsensors 2 ist in Fig. 2 mit 30 bezeichnet. Die Haupterfassungsrichtung des Ultraschallsensors 2 ist entlang dieser Sensorachse 30 definiert.

Um den Entkopplungsring 29 herum befindet sich die Versteifungseinheit 15. In diesem Ausführungsbeispiel ist die Versteifungseinheit 15 auch in radialer Richtung 31 unterteilt und beinhaltet insgesamt zwei konzentrisch zueinander angeordnete Ringstrukturen 32, 33. Die Ringstrukturen 32, 33 sind in radialer Richtung 31 beabstandet zueinander angeordnet. Jede Ringstruktur 32, 33 ist in zumindest zwei Ringsektoren bzw. Versteifungsteile unterteilt, nämlich in Umfangsrichtung. Gegebenenfalls kann lediglich eine der Ringstrukturen 32, 33 unterteilt sein, während die andere Ringstruktur 32, 33 einen durchgehend umlaufenden Ring bilden kann.

Die Versteifungseinheit 15 ist mit ihrer Frontseite 26 an der Rückseite 28 des Verkleidungsteils 27 anliegend angebracht und mit der Rückseite 28 beispielsweise verklebt.

Die Versteifungsteile der jeweiligen Ringstrukturen 32, 33 können auf der vom Verkleidungsteil 27 abgewandten Seite miteinander über einen dünnen Steg 34 verbunden sein, was die Montage der Ultraschallsensorvorrichtung 1 wesentlich vereinfacht. Der Steg 34 hat dabei keine Versteifungsfunktion und ist bevorzugt aus einem deutlich weicheren Material als die Versteifungseinheit 15 gebildet, nämlich beispielsweise aus Silikon oder aber aus Kunststoff. Der Steg 34 ändert also nichts daran, dass sich die einzelnen Versteifungsteile bzw. die einzelnen Ringstrukturen 32, 33 gegenseitig nicht berühren.

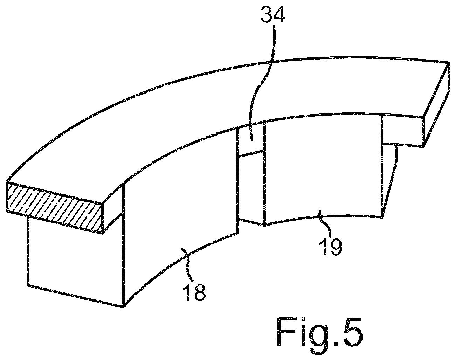

Ein solcher Steg 34 kann auch zwischen zwei benachbarten Versteifungsteilen 18, 19 ein und derselben Ringstruktur 32, 33 vorgesehen sein, wie dies beispielhaft in Fig. 5 dargestellt ist. Hier sind die beiden benachbarten Versteifungsteile 18, 19 über einen solchen Steg 34 miteinander in Umfangsrichtung verbunden und können somit gemeinsam gehandhabt werden.

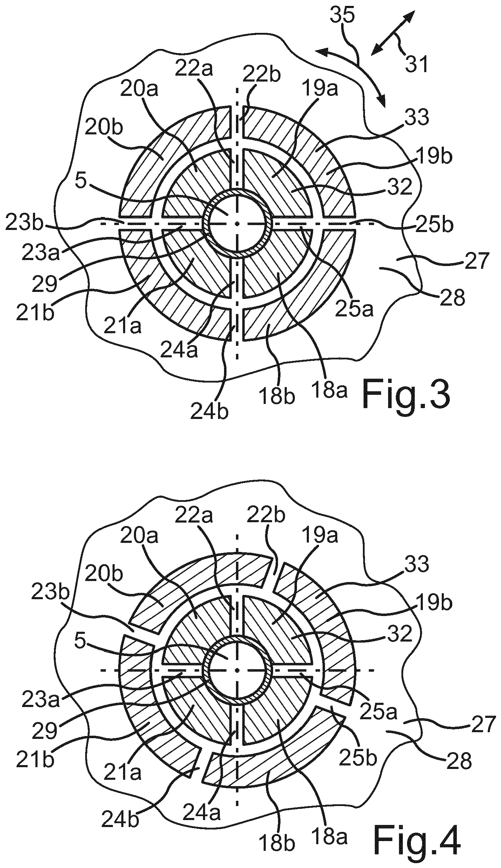

In Fig. 3 ist eine Draufsicht bzw. eine Schnittdarstellung durch die Anordnung gemäß Fig. 2 entlang der Linie III-III zusammen mit der Rückseite 28 des Verkleidungsteils 27 dargestellt. Wie aus Fig. 3 hervorgeht, sind die beiden Ringstrukturen 32, 33 jeweils auch in Umfangsrichtung 35 in vier Versteifungsteile 18a bis 21a bzw. 18b bis 21b unerteilt, wobei die Versteifungsteile 18 bis 21 jeweils einen Viertel der jeweiligen Ringstruktur 32, 33 bilden.

Zwischen jeweils zwei in Umfangsrichtung benachbarten Versteifungsteilen 18 bis 21 ist jeweils ein Schlitz 22a bis 25a bzw. 22b bis 25b ausgebildet. Diese Schlitze erstrecken sich in radialer Richtung 31 geradlinig. Die beiden Ringstrukturen 32, 33 sind im Ausführungsbeispiel gemäß Fig. 3 derart relativ zueinander angeordnet, dass die jeweiligen Versteifungsteile 18a bis 21a einerseits sowie 18b bis 21b andererseits in gleichen Winkelpositionen zueinander angeordnet sind. Somit fallen auch die jeweiligen Schlitze 22a bis 25a einerseits sowie 22b bis 25b andererseits in gleichen Winkelpositionen zusammen.

Demgegenüber ist in Fig. 4 eine Ausführungsform gezeigt, bei welcher die Versteifungsteile 18a bis 21a der inneren Ringstruktur 32 winkelversetzt zu den Versteifungsteilen 18b bis 21b der äußeren Ringstruktur 33 angeordnet sind. Somit fallen auch die jeweiligen Schlitze 22a bis 25a einerseits sowie 22b bis 25b andererseits nicht mehr zusammen, sondern sind in unterschiedlichen Winkelpositionen zueinander angeordnet.

Die Anzahl der Versteifungsteile 18 bis 22 sowie deren Anordnung relativ zueinander sind in den Figuren lediglich beispielhaft dargestellt und können je nach Ausführungsform variiert werden.

Der Außendurchmesser der gesamten Versteifungseinheit 15 entspricht im Wesentlichen bzw. ist ein wenig kleiner als der Durchmesser des umlaufenden Stegs 16 der Halteeinrichtung 8 (siehe Fig. 1). Unabhängig von der Anzahl der konzentrischen Ringstrukturen 32, 33 bleibt der Außendurchmesser der gesamten Versteifungseinheit 15 bevorzugt gleich, so dass je mehr Versteifungsteile vorgesehen sind, desto kleiner diese Versteifungsteile sind.

Die Versteifungseinheit 15 verhindert einerseits das Entstehen größerer Schwingungsamplituden des Verkleidungsteils 27. Andererseits gibt die Versteifungseinheit 15 auch ihre in ihr eingebrachte Bewegungsenergie zum Teil an das Verkleidungsteil 27 wieder weiter. Deshalb sollte die in die Versteifungseinheit 15 eingebrachte Energie so gering wie möglich gehalten werden. Bei einer einstückig ausgebildeten Versteifungseinheit wird im Stand der Technik mehr Bewegungsenergie in diesen Versteifungsring eingebracht, als dies bei der segmentierten Versteifungseinheit 15 gemäß der Erfindung der Fall ist. Dies deshalb, weil sich bei der einstückig ausgebildeten Versteifungseinheit 15 die jeweilige Schwingform über den gesamten Umfang und somit über eine größere Länge ausbreiten kann. Durch die vorgeschlagene Segmentierung wird sich die eingebrachte Bewegungsenergie hauptsächlich innerhalb der einzelnen Segmente ausbreiten und die jeweilige Schwingform kann sich nicht über den gesamten Umfang ausbreiten. Durch diesen reduzierten Bewegungsenergieeintrag in die Versteifungseinheit 15 wird somit auch weniger Bewegungsenergie in das Verkleidungsteil 27 eingebracht, was zu einer Verringerung der unerwünschten Schwingungen selbigen Verkleidungsteils 27 führt und somit zu einer Verringerung der unerwünschten Schallabstrahlung nach hinten. Ein einzelnes Versteifungsteil 18 bis 21 ist des Weiteren auch durch die vorgeschlagene Segmentierung deutlich steifer, nämlich aufgrund des insgesamt geringeren Längen-/Höhen-Verhältnisses.

## Patentansprüche

1. Ultraschallsensorvorrichtung (1) für ein Kraftfahrzeug, mit einem Ultraschallsensor (2), welcher eine Membran (5) zum Aussenden und/oder Empfangen von Ultraschallwellen aufweist, und mit einer Versteifungseinheit (15) zum Anbringen an einem Verkleidungsteil (27) des Kraftfahrzeugs und zum Versteifen des Verkleidungsteils (27), wobei die Versteifungseinheit (15) eine Durchgangsöffnung (17) für die Membran (5) des Ultraschallsensors (2) aufweist, wobei die Versteifungseinheit (15) zumindest zwei separate Versteifungsteile (18 bis 21) aufweist, welche zum Anbringen an dem Verkleidungsteil (27) und zum Versteifen des Verkleidungsteils (27) ausgebildet sind, wobei zumindest zwei Versteifungsteile (18 bis 21) aus unterschiedlichen Materialien gebildet sind,
**dadurch gekennzeichnet, dass**
in Umfangsrichtung (35) die Versteifungseinheit (15) in zumindest zwei Versteifungsteile (18 bis 21) unterteilt ist, die in Umfangsrichtung (35) beabstandet zueinander angeordnet sind.

2. Ultraschallsensorvorrichtung (1) nach Anspruch 1,
**dadurch gekennzeichnet, dass**
in radialer Richtung (31) die Versteifungseinheit (15) zumindest zwei konzentrisch zueinander angeordnete Ringstrukturen (32, 33) aufweist, die in radialer Richtung (31) beabstandet zueinander angeordnet sind.

3. Ultraschallsensorvorrichtung (1) nach Anspruch 2,
**dadurch gekennzeichnet, dass**
zumindest eine der Ringstrukturen (32, 33) in Umfangsrichtung (35) in zumindest zwei Ringsektoren als Versteifungsteile (18 bis 21) unterteilt ist, welche in Umfangsrichtung (35) beabstandet zueinander angeordnet sind.

4. Ultraschallsensorvorrichtung (1) nach einem der vorhergehenden Ansprüche,
**dadurch gekennzeichnet, dass**
durch die Versteifungseinheit (15) insgesamt eine Ringform bildet ist.

5. Ultraschallsensorvorrichtung (1) nach einem der vorhergehenden Ansprüche,
**dadurch gekennzeichnet, dass**
zumindest zwei Versteifungsteile (18 bis 21) aus gleichem Material gebildet sind.

6. Ultraschallsensorvorrichtung (1) nach einem der vorhergehenden Ansprüche,
**dadurch gekennzeichnet, dass**
zumindest eines der Versteifungsteile (18 bis 21) aus Keramik, insbesondere aus Aluminiumoxid und/oder aus Siliziumcarbid, gebildet ist.

7. Ultraschallsensorvorrichtung (1) nach einem der vorhergehenden Ansprüche,
**dadurch gekennzeichnet, dass**
die zumindest zwei Versteifungsteile (18 bis 21) über einen Steg (34) miteinander verbunden sind, welcher aus einem gegenüber dem Material der Versteifungseinheit (15) weniger steifen Material gebildet ist.

8. Ultraschallsensorvorrichtung (1) nach Anspruch 7,
**dadurch gekennzeichnet, dass**
der Steg (34) aus Silikon und/oder aus Kunststoff gebildet ist.

9. Ultraschallsensorvorrichtung (1) nach einem der vorhergehenden Ansprüche,
**dadurch gekennzeichnet, dass**
die Ultraschallsensorvorrichtung (1) eine mit der Versteifungseinheit (15) verbundene Halteeinrichtung (8) aufweist, an welcher der Ultraschallsensor (2), insbesondere reversibel lösbar, befestigbar ist.

10. Anordnung für ein Kraftfahrzeug, mit einem Verkleidungsteil (27), insbesondere einem Stoßfänger, und mit einer an einer Rückseite (28) des Verkleidungsteils (27) angeordneten Ultraschallsensorvorrichtung (1) nach einem der vorhergehenden Ansprüche, wobei der Ultraschallsensor (2) zum Aussenden und/oder Empfangen der Ultraschallsellen durch das Verkleidungsteil (27) hindurch ausgebildet ist und die Versteifungseinheit (15) an der Rückseite (28) des Verkleidungsteils (27) anliegend angebracht ist.

11. Kraftfahrzeug mit einer Anordnung nach Anspruch 10.

12. Verfahren zum Herstellen einer Anordnung für ein Kraftfahrzeug durch Bereitstellen eines Verkleidungsteils (27), insbesondere eines Stoßfängers, Bereitstellen eines Ultraschallsensors (2) mit einer Membran (5) zum Aussenden und/oder Empfangen von Ultraschallwellen, und Bereitstellen einer Versteifungseinheit (15) und Anbringen der Versteifungseinheit (15) an einer Rückseite des Verkleidungsteils (27), wobei die Versteifungseinheit (15) eine Durchgangsöffnung (17) aufweist, durch welche die Membran (5) hindurch gesteckt wird, wobei die Versteifungseinheit (15) aus zumindest zwei separaten Versteifungsteilen (18 bis 21) gebildet wird, wobei zumindest zwei Versteifungsteile (18 bis 21) aus unterschiedlichen Materialien gebildet werden,
**dadurch gekennzeichnet, dass**
in Umfangsrichtung (35) die Versteifungseinheit (15) in zumindest zwei Versteifungsteile (18 bis 21) unterteilt wird, die in Umfangsrichtung (35) beabstandet zueinander angeordnet werden.

## Claims

1. An ultrasonic sensor device (1) for a motor vehicle, comprising an ultrasonic sensor (2), which comprises a membrane (5) for emitting and/or receiving ultrasonic waves, and comprising a stiffening unit (15) for attaching to a trim part (27) of the motor vehicle and for stiffening the trim part (27), wherein the stiffening unit (15) comprises a passage opening (17) for the membrane (5) of the ultrasonic sensor (2), wherein the stiffening unit (15) comprises at least two separate stiffening parts (18 to 21), which are formed for attaching to the trim part (27) and for stiffening the trim part (27), wherein at least two stiffening parts (18 to 21) are formed of different materials,
**characterized in that**
the stiffening unit (15) is divided into at least two stiffening parts (18 to 21) in circumferential direction (35), which are arranged spaced from each other in circumferential direction (35).

2. The ultrasonic sensor device (1) according to claim 1,
**characterized in that**
in radial direction (31), the stiffening unit (15) comprises at least two ring structures (32, 33) arranged concentrically to each other, which are arranged spaced from each other in radial direction (31).

3. The ultrasonic sensor device (1) according to claim 2,
**characterized in that**
at least one of the ring structures (32, 33) is divided into at least two ring sectors as stiffening parts (18 to 21) in circumferential direction (35), which are arranged spaced from each other in circumferential direction (35).

4. The ultrasonic sensor device (1) according to any one of the preceding claims,
**characterized in that**
a ring shape is overall formed by the stiffening unit (15).

5. The ultrasonic sensor device (1) according to any one of the preceding claims,
**characterized in that**
at least two stiffening parts (18 to 21) are formed of the same material.

6. The ultrasonic sensor device (1) according to any one of the preceding claims,
**characterized in that**
at least one of the stiffening parts (18 to 21) is formed of ceramic, in particular of aluminum oxide and/or of silicon carbide.

7. The ultrasonic sensor device (1) according to any one of the preceding claims,
**characterized in that**
the at least two stiffening parts (18 to 21) are connected to each other via a web (34), which is formed of a material less stiff with respect to the material of the stiffening unit (15).

8. The ultrasonic sensor device (1) according to claim 7,
**characterized in that**
the web (34) is formed of silicone and/or of plastic.

9. The ultrasonic sensor device (1) according to any one of the preceding claims,
**characterized in that**
the ultrasonic sensor device (1) comprises a retaining device (8) connected to the stiffening unit (15), to which the ultrasonic sensor (2) can be, in particular reversibly detachably, fixed.

10. An assembly for a motor vehicle, comprising a trim part (27), in particular a bumper, and comprising an ultrasonic sensor device (1) according to any one of the preceding claims arranged on a rear side (28) of the trim part (27), wherein the ultrasonic sensor (2) is formed for emitting and/or receiving the ultrasonic waves through the trim part (27) and the stiffening unit (15) is attached abutting on the rear side (28) of the trim part (27).

11. A motor vehicle with an assembly according to claim 10.

12. A method for producing an assembly for a motor vehicle by providing a trim part (27), in particular a bumper, providing an ultrasonic senor (2) with a membrane (5) for emitting and/or receiving ultrasonic waves, and providing a stiffening unit (15) and attaching the stiffening unit (15) to a rear side of the trim part (27), wherein the stiffening unit (15) comprises a passage opening (17), through which the membrane (5) is inserted, wherein the stiffening unit (15) is formed of at least two separate stiffening parts (18 to 21), wherein at least two stiffening parts (18 to 21) are formed of different materials,
**characterized in that**
the stiffening unit (15) is divided into at least two stiffening parts (18 to 21) in circumferential direction (35), which are arranged spaced from each other in circumferential direction (35).

## Revendications

1. Dispositif à capteur à ultrasons (1) destiné à un véhicule automobile, ledit dispositif comprenant un capteur à ultrasons (2), qui comporte une membrane (5) destinée à transmettre et/ou recevoir des ondes ultrasonores, et une unité de rigidification (15) destinée à être montée sur une pièce d'habillage (27) du véhicule automobile et à rigidifier la pièce d'habillage (27), l'unité de rigidification (15) comportant une ouverture traversante (17) destinée à la membrane (5) du capteur à ultrasons (2), l'unité de rigidification (15) comportant au moins deux pièces de rigidification séparées (18 à 21) qui sont conçues pour être montées sur la pièce d'habillage (27) et pour rigidifier la pièce d'habillage (27), au moins deux pièces de rigidification (18 à 21) étant formées à partir de matériaux différents,
**caractérisé en ce que**
l'unité de rigidification (15) est subdivisée, dans la direction périphérique (35), en au moins deux pièces de rigidification (18 à 21) qui sont disposées à distance l'une de l'autre dans la direction périphérique (35).

2. Dispositif à capteur à ultrasons (1) selon la revendication 1,
**caractérisé en ce que**
l'unité de rigidification (15) comporte, dans la direction radiale (31), au moins deux structures annulaires (32, 33) qui sont disposées concentriquement l'une à l'autre et qui sont disposées à distance l'une de l'autre dans la direction radiale (31).

3. Dispositif à capteur à ultrasons (1) selon la revendication 2,
**caractérisé en ce que**
l'une au moins des structures annulaires (32, 33) est subdivisée, dans la direction périphérique (35), en au moins deux secteurs d'anneau servant de pièces de rigidification (18 à 21) qui sont disposées à distance l'une de l'autre dans la direction périphérique (35).

4. Dispositif à capteur à ultrasons (1) selon l'une des revendications précédentes,
**caractérisé en ce que**
une forme générale d'anneau est formée par l'unité de rigidification (15).

5. Dispositif à capteur à ultrasons (1) selon l'une des revendications précédentes,
**caractérisé en ce que**
au moins deux pièces de rigidification (18 à 21) sont formées à partir du même matériau.

6. Dispositif à capteur à ultrasons (1) selon l'une des revendications précédentes,
**caractérisé en ce que**
l'une au moins des pièces de rigidification (18 à 21) est formée à partir de céramique, notamment d'oxyde d'aluminium et/ou de carbure de silicium.

7. Dispositif à capteur à ultrasons (1) selon l'une des revendications précédentes,
**caractérisé en ce que**
les au moins deux pièces de rigidification (18 à 21) sont reliées l'une à l'autre par une nervure (34) qui est formée à partir d'un matériau moins rigide que le matériau de l'unité de rigidification (15).

8. Dispositif à capteur à ultrasons (1) selon la revendication 7,
**caractérisé en ce que**
la nervure (34) est formée à partir de silicone et/ou de matière synthétique.

9. Dispositif à capteur à ultrasons (1) selon l'une des revendications précédentes,
**caractérisé en ce que**
le capteur à ultrasons (1) comporte un dispositif de retenue (8) qui est relié à l'unité de rigidification (15) et auquel le capteur à ultrasons (2) peut être fixé, notamment de manière amovible.

10. Ensemble destiné à un véhicule automobile, ledit ensemble comprenant une pièce d'habillage (27), notamment un pare-chocs, et un dispositif à capteur à ultrasons (1) disposé sur un côté arrière (28) de la pièce d'habillage (27) selon l'une des revendications précédentes, le capteur à ultrasons (2) étant conçu pour émettre et/ou recevoir les ondes ultrasonores par le biais de la pièce d'habillage (27) et l'unité de rigidification (15) étant montée sur le côté arrière (28) de la pièce d'habillage (27).

11. Véhicule automobile comprenant un ensemble selon la revendication 10.

12. Procédé de fabrication d'un ensemble destiné à un véhicule automobile, le procédé comprenant les étapes suivantes : fournir une pièce d'habillage (27), en particulier un pare-chocs, fournir un capteur à ultrasons (2) comportant une membrane (5) destinée à émettre et/ou recevoir des ondes ultrasonores et fournir une unité de rigidification (15) et monter l'unité de rigidification (15) sur un côté arrière de la pièce d'habillage (27), l'unité de rigidification (15) comportant une ouverture traversante (17) à travers laquelle la membrane (5) est insérée, l'unité de rigidification (15) étant formée d'au moins deux pièces de rigidification séparées (18 à 21), les au moins deux pièces de rigidification (18 à 21) étant formées à partir de matériaux différents,
**caractérisé en ce que**
l'unité de rigidification (15) est divisée, dans la direction périphérique (35), en au moins deux pièces de rigidification (18 à 21) qui sont disposées à distance l'une de l'autre dans la direction périphérique (35).
